Europäisches Patentamt

European Patent Office

Office européen des brevets

(19)

(11) Publication number: **0 164 806 B1**

## EUROPEAN PATENT SPECIFICATION

(12)

(45) Date of publication of patent specification: **18.03.92**

(51) Int. Cl.⁵: **H03D 13/00**, H03L 7/14

(21) Application number: **85200903.4**

(22) Date of filing: **07.06.85**

(54) **PLL-circuit.**

(30) Priority: **11.06.84 US 619093**
**11.06.84 US 619096**

(43) Date of publication of application:
**18.12.85 Bulletin 85/51**

(45) Publication of the grant of the patent:
**18.03.92 Bulletin 92/12**

(84) Designated Contracting States:
**DE FR GB IT**

(56) References cited:
**DE-A- 3 115 057**
**US-A- 4 020 422**

**IEEE TRANSACTIONS ON COMMUNICA-
TIONS, vol. COM-27, no. 9, September 1979,
pages 1288-1295, IEEE, New York, US; D.G.
MESSERSCHMITT: "Frequency detectors for
PLL acquisition in timing and carrier recov-
ery"**

**IBM TECHNICAL DISCLOSURE BULLETIN, vol.
23, no. 1, June 1980, pages 81-82, New York,
US; M.L. CARNES et al.: "Cycle-synchronized
phase-locked loop"**

(73) Proprietor: **N.V. Philips' Gloeilampenfabrieken
Groenewoudseweg 1
NL-5621 BA Eindhoven(NL)**

(72) Inventor: **Yarborough, John Milton
c/o INT. OCTROOIBUREAU B.V. Prof. Holst-
laan 6
NL-5656 AA Eindhoven(NL)**

(74) Representative: **Faessen, Louis Marie Huber-
tus et al
INTERNATIONAAL OCTROOIBUREAU B.V. 6
Prof. Holstlaan
NL-5656 AA Eindhoven(NL)**

Note: Within nine months from the publication of the mention of the grant of the European patent, any person
may give notice to the European Patent Office of opposition to the European patent granted. Notice of opposition
shall be filed in a written reasoned statement. It shall not be deemed to have been filed until the opposition fee
has been paid (Art. 99(1) European patent convention).

**Description**

The invention relates to a phase locked loop (PLL) circuit comprising

- a voltage controlled oscillator (VCO) with an oscillator output which is coupled to a first input of a frequency detector and to a first input of a phase detector, the outputs of the frequency and phase detectors being coupled to first and second inputs respectively of a loop filter ($R_1$, $R_2$, $C_F$), whose output is coupled to a control input of the VCO;

- the phase detector (10) being provided with a data input for receiving a data signal (DATIN) and comprising a digital comparison circuit generating an output signal as a result of a sequence of comparisons of a cycle of the data signal with a cycle of a signal from the VCO, whereby the comparison circuit is triggered each time by the start of a data signal (DATIN) and the generated output signal is either in a first state (PU) from said start of a data signal to the next transition of the oscillator output signal (VCOIN) if the oscillator output signal is at a first state at said start or in a second state (PD) during the next full time interval in which the oscillator output signal is in the first state, if the oscillator output signal is in a second state at said start. Such phase locked loop circuits may be part of a disk phase locked loop circuit like the Signetics SCB 68549 integrated circuit. Further PLL circuits are known from IEEE Transactions on Communications Vol. Com 27, No. 9, September 1979, pages 1288-1295 "Frequency Detectors for PLL Acquisition in Timing and Carrier Recovery", David G. Messerschmitt.

As summarized in said publication the initial acquisition of a phase locked loop when used for timing or carrier extraction is a significant practical problem, since the narrow bandwidth generally required for jitter requirements severely restricts the pulling range. In the cited prior art several methods have been used to effect the acquisition.

This article further shows an arrangement of a frequency detector for the coarse regulation of a voltage controlled oscillator (VCO) and a phase detector for its fine adjustment. Both the phase and the frequency detector are receiving the VCO frequency signal and the data input signal.

In a PLL circuit used for carrier extraction the data input signal is often interrupted (e.g. due to a rather long series of "zeroes" or movements of a read head in a disk storage medium). As a result of the discontinuous data input signal (missing data signals) the PLL circuit will detune the VCO. So the PLL circuit will not quickly lock to a new data signal, although it has approximately the same frequency as the interrupted data signal. In the described PLL circuits the acquisition time is relatively long because the phase and frequency detectors regulate the VCO to its maximal or minimal oscillating frequency when the data signal is interrupted. As a result the first received new data signals will be stumbled.

A phase locked loop circuit in which a digital phase comparison circuit is used is known from DE-A 31 15 057. The digital comparison circuit only reacts to transitions of the data or the VCO-frequency signal in one direction and is insensitive to the actual duty cycle or frequency of the incoming signals. In the known circuit no separate frequency detector is foreseen. For a proper operation of the known PLL it is necessary that both the VCO-frequency signal and the data signal are present. In the before described use the data signal may be absent during a prolonged period, a situation that can not be handled satisfactorily by the known circuit.

It is an object of the invention to provide a PLL circuit that will keep the oscillating frequency of the VCO near the frequency of the next incoming data signal during absence of the data signals and will generate output signals that result in a relatively ripple-free control signal for the VCO.

The PLL-circuit according to the invention is set out in Claim 1. When data signals are absent, the phase detector will not be triggered and thus does not generate an output signal which influences the oscillating frequency of the VCO. After each comparison the phase detector generates a single polarity output signal. In general, several succeeding comparisons will result in succeeding output signals with the same polarity and can easily be filtered by simple filter means to form a relatively ripple-free control signal for the VCO. A PLL as defined hereinbefore and comprising a phase detector according to the invention will be tuned to the reference frequency applied to the reference frequency input of the frequency detector. The reference frequency given be chosen as close to the clock frequency of the data signal as possible. Such provisions accelerate the locking of the PLL to the next incoming data signal after an interruption.

By itself, US patent 4020422 describes a phase comparator indicating a phase difference range of n x 360°, between two input signals, comprising edge triggered shift registers, for dividing the input signals by n, means for modulating the width of the resulting output pulses in proportion to the phase difference of the input signals, and integrating means to combine the modulated pulses into a time-averaged signal which is indicative of the phase difference. Further attractive aspects of the invention are recited in dependent claims.

The invention will be described with reference to the following Figures, in which

Figure 1 shows a PLL circuit in which the phase and frequency detectors according to the invention may be used

Figure 2 shows a phase detection according to the invention

Figure 3 shows an embodiment of a frequency detector

Figure 4 shows a further embodiment of a frequency detector

Figure 5 shows a state-event diagram of the frequency detector in Figure 4.

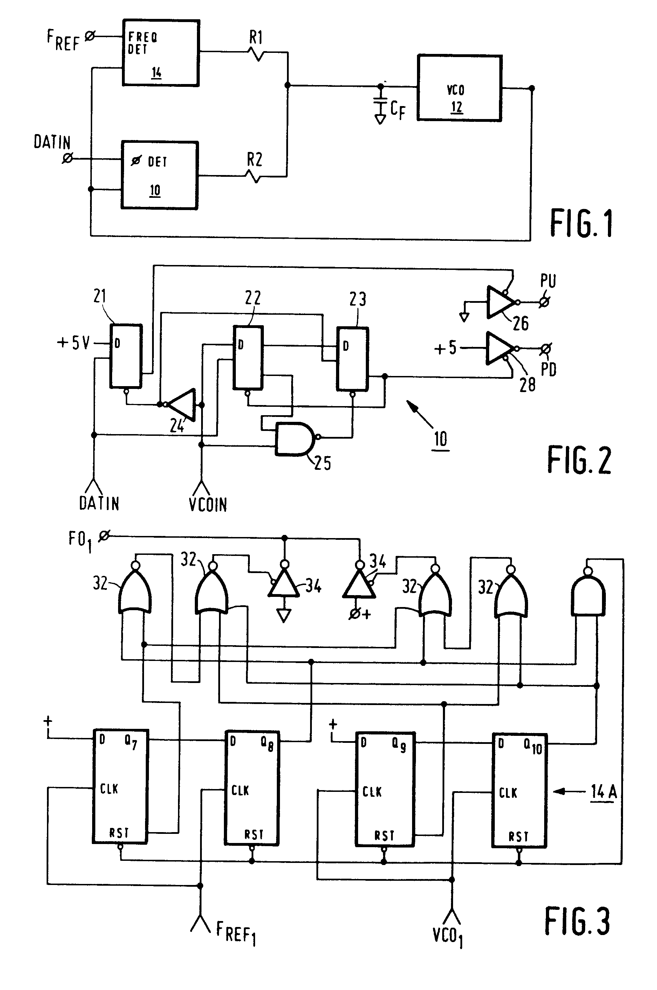

In Figure 1 a PLL circuit is shown which maintains the voltage controlled oscillator (VCO) of the phase locked loop operating near a frequency to which it will be locked even when the locking signal is absent. In this PLL curcuits it is possible to control the lock and capture range of a phase locked loop. The circuit consists of an interconnection of three principle logic circuits; a phase detector (10), a frequency detector (14) and a VCO (12). Two resistors R1, R2 and a capacitor CF constitute a loop filter. The phase detector is a design that is insensitive to missing pulses, therefore the circuit is effective in recovering the clock from data that uses Miller, Manchester or other encoding schemes.

The operation of the circuit is similar to a standard PLL circuit except that a second control source providing a reference frequency $F_{ref}$ is to be used. By changing the ratio of the resistors R1 and R2 in the loop filter, the effect of the frequency detector on lock in and lock range can be varied. At any time during which no pulses are being received by the phase detector, the loop will be locked to the reference frequency which is received at the $F_{ref}$ input of the frequency detector and may be generated by e.g. a cristal oscillator. This can be thought of as a means for keeping the loop locked to some nominal frequency while awaiting the arrival of the data signal. In order for this circuit to operate in the desired manner, it is important that the output signals of the frequency detector be a function of the frequency difference between its two inputs (the VCO output and $F_{ref}$) and not the phase difference between the two.

A phase detector 10 (∅ DET) also receives the VCO output signal. The output signals of the frequency detector 14 and the phase detector 10 are sent to the voltage controlled oscillator 12 to maintain its oscillating frequency near or at the frequency to which it will be locked. The circuit of the present invention, when used in a phase locked loop for controlling up to 4 memory discs, either floppy discs or hard discs, is to produce an oscillator frequency to match the frequency of the data signal, received on the input DATIN, locked condition, any slight change of the input frequency, called jitter, will appear as a change in phase between the data signal and the voltage controlled oscillator frequency. This phase shift then acts as a signal to adjust the frequency of the phase locked loop voltage controlled oscillator 12 to match the input frequency.

Referring now to Figure 2, it should be noted that the phase detector circuit 10 shown assumes that when voltage on the input from the voltage controlled oscillator 12 is increased, the output frequency increases. It is of course possible to design the PLL circuit so that voltage controlled oscillator circuits with the reverse characteristics may be used. The starting state is for the output of all three flip flops (21, 22, 23) to be in their reset, or zero state. The description that follows will show that this state can reached regardless of any arbitrary starting state.

If a rising edge occurs on data input DATIN, while the VCO signal on a first input VCOIN is low, flip flop 21 is set. While set, the output of flip flop 21 activates inverter 26. As a result the pump-up signal (PU) is active. When the VCO signal on the input VCOIN goes high, the output of inverter 24 goes low resetting flip flop 21, the output of which switching off inverter 26, thus disabling the pump-up signal (PU). The output of inverter 24 also prevents flip flop 21 from being set by positive transitions on the data input DATIN when the VCO signal is high.

If a rising edge occurs on data input DATIN while the VCO signal on input "VCOIN is high, the flip flop 22 is set. On the next falling VCO edge, the output of inverter 24 goes from low to high and flip flop 23 is set, thus causing its inverting output to go low and clear flip flop 22. While flip flop 23 is set, its output activates inverter 28 and thus the pump-down signal (PD) is active. When the VCO signal returns to its high state, the output of gate 25 goes low and flip flop 23 is cleared, deactivating the inverter 28 and the pump-down signal.

This logic causes the pump-up signal (PU) to be active from a rising edge of the data signals on input DATIN that occurs while VCO signal is low until the VCO signal rises. The pump-down (PD) is active for the full low half VCO period that follows a rising edge of the data signal which occurred during a VCO high time.

Each output signal, which in a typical application is sent through a low pass filter before being used to control the frequency of a voltage controlled oscillator 12, has two states. Since one state is common to both pump-up (Pin) and pump-down (PD), there is a total of three output states. If pump-up (PU) is active, the signal can be thought of as being connected to the positive supply. If pump-down (PD) is active, the signal can be thought of as being connected to ground. When inactive, the pump-up output and pump-down

EP 0 164 806 B1

output can be thought of as being an open circuit. Thus it is that the three states, pump-up active, pump-down active and inactive are identical to those of tristate drivers.

The detector thus disclosed has a linear relationship between phase error and pump-up pulse width, but a fixed pump-down pulse width for all phase errors for which the signal is generated. The effect of this operation cam be thought of as follows. A normal linear relationship between phase error for both pump-up and pump-down results in a phase error probability distribution that is Gaussian, centered at zero error. In the circuit illustrated in Figure 2, the resulting distribution is similar except that for a VCO with a positive characteristic the distribution is centered about a point at which the input is leading the VCO by some phase difference. The exact location is determined by the ratio of two resistors R1 and R2 connected from pump-up output and pump-down output to the loops's integrating capacitor CF.

Figure 3 shows a first embodiment of a frequency detector 14A. A series of flip flops (Q7, Q8, Q9, Q10), a series of NOR-gates 32 leading to a pair of tristate drivers 34. The two inputs are labeled $F_{ref1}$ for the reference frequency input and VCO, for the input, which has been connected to the output of the voltage controlled oscillator (12) in the loop (see Figure 1). The output of the frequency detector circuit 14 is labelled FO1. The reference frequency and the VCO frequency signals are assumed to be digital signals with a fixed, at least on a short term basis, frequency. The signals however need not be square waves since only one edge, in the case of the embodiment of Figure 3 the rising edge, has an effect on the circuit 14A . The output signal of the circuit 14A, which is sent through a low pass filter before being used to control the frequency of the voltage controlled oscillator 12, has three states. The first state is pump-up, in which case the signal may be thought of as being connected to the positive supply. The second state is pump-down, in which case the signal may be thought of as being connected to ground. The third state is inactive in which case the output FO1 can be thought of as being an open circuit.

The operation of the circuit is as follows.

The starting state is for all four flip flops is to be in their reset or zero state. The description that follows will show that this state will be reached regardless of any arbitrary starting state. A transition on either the $F_{ref1}$ or the $VCO_1$ input will cause the flip flop pair Q7, Q8 or Q9, Q10 to assume the state 1, 0. The next positive edge causes the state of the affected pair to advance to 1,1. When both Q8 and Q10 are in the 1 state a direct clear will be effected returning the flip flops to their original states. A list of all possible stable states for Q7, Q8, Q9, Q10 and the associated pump-up/pump-down action follows. All states are of the form X1X1 are not included since they are unstable and are cleared to 0000. States of the form O1XX and XXO1 are not included since they cannot be reached from the starting state 0000. However, if these states should occur after e.g. powering-up the circuit, the flip flops will be in their reset state after a few cycles of the VCO or reference frequency.

| Q7 | Q8 | Q9 | Q10 | Pup | Pdown |
|----|----|----|-----|-----|-------|
| 0 | 0 | 0 | 0 | 0 | 0 |
| 0 | 0 | 1 | 0 | 0 | 1 |
| 0 | 0 | 1 | 1 | 0 | 0 |
| 1 | 0 | 0 | 0 | 1 | 0 |
| 1 | 1 | 0 | 0 | 0 | 0 |
| 1 | 1 | 1 | 0 | 0 | 1 |
| 1 | 0 | 1 | 0 | 0 | 0 |
| 1 | 0 | 1 | 1 | 1 | 0 |

Analysis of the results of this circuit will show that when the reference frequency is greater than the VCO frequency over the course of one cycle of the reference frequency and one cycle of the VCO frequency, there will be a net pump-up signal, that is the pump-up width will be greater than the pump-down width. When the reference frequency is less than the VCO frequency there will be net pump-down. These net signals are independent of the phase difference between the reference frequency and the VCO frequency signals.

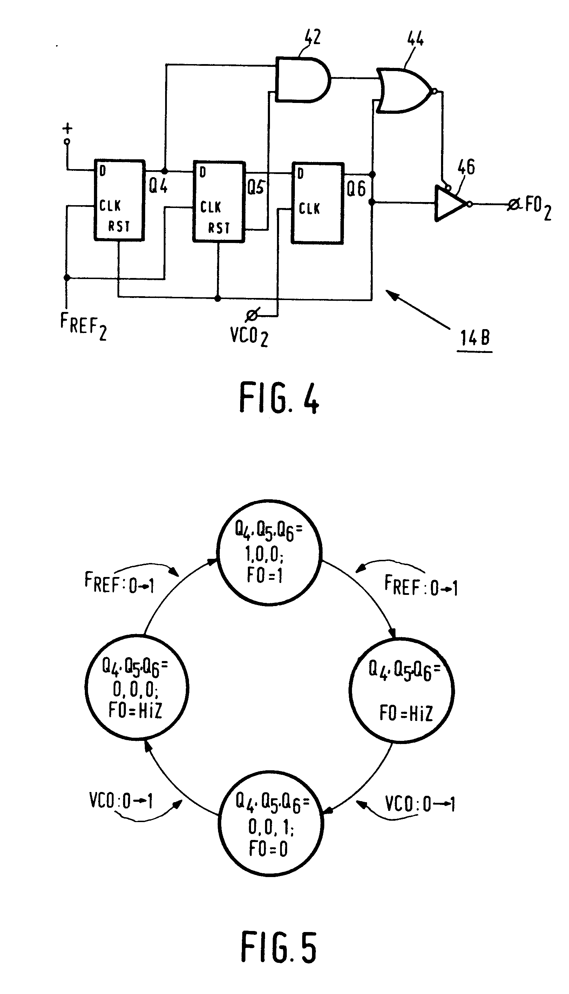

Figure 4 shows a further embodiment of a frequency detector 14B . The detector comprises three D-type flip flops (Q4, Q5, Q6), an AND-gate (42), a NOR-gate (44) and a tristate driver (46). This frequency detector is provided with the inputs $F_{ref2}$ and $VCO_2$ and an output $FO_2$. The functioning of this detector is illustrated by the state event diagram of Figure 5.

In a starting condition, all three flip flops (Q4, Q5, Q6) are in a zero state, meaning that their non-inverting outputs are at logical "zero" value, and consequently their inverting outputs are at "one". The AND- (42) and NOR- (44) gates render the tristate driver (46) inactive, which means that it can be thought of

4

as having a extremely high output impedance (HiZ) or even as an open circuit. A rising edge in the reference frequency on input $F_{ref2}$ sets flip flop Q4 to its "one" state, which activates the tristate driver (46) and generates a pump-up signal at the output $FO_2$. After receiving the next rising edge on input $F_{ref2}$ flip flop Q5 also is set to "one", disabling the tristate driver (46). The frequency detector 14B awaits a rising edge in the VCO signal on input $VCO_2$, on which the flip flop Q6 is set to "one". The high output signal of flip flop Q6 resets both flip flops Q4 and Q5 and generates the pump-down signal at the output $FO_2$ through the tristate driver (46), which has been enabled via NOR-gate 44.

On the next rising edge on the input $VCO_2$, the flip flop Q6 takes the "zero" state over from flip flop Q5 and renders the tristate driver (46) inactive. At this instant the first state has been reached again and a new cycle of states may be started.

It will be noted that the output $FO_2$ generates a "pump-up" signal during a full period of the reference frequency and afterwards generates a "pump-down" signal during the following full period of the VCO output signal. By applying these signals to the loop filter, a control voltage for the VCO 12 is generated. (See Figure 1).

## Claims

1.  A phase locked loop (PLL) circuit comprising
    - a voltage controlled oscillator (VCO) (12) with an oscillator output which is coupled to a first input of a frequency detector (14) and to a first input of a phase detector (10), the outputs of the frequency and phase detectors being coupled to first and second inputs respectively of a loop filter ($R_1$, $R_2$, $C_F$), whose output is coupled to a control input of the VCO (12);
    - the phase detector (10) being provided with a data input for receiving a data signal (DATIN) and comprising a digital comparison circuit generating an output signal as a result of a sequence of comparisons of a cycle of the data signal with a cycle of a signal from the VCO, whereby the comparison circuit is triggered each time by the start of a data signal (DATIN) and the generated output signal is either in a first state (PU) from said start of a data signal to the next transition of the oscillator output signal (VCOIN) if the oscillator output signal is at a first state at said start or in a second state (PD) during the next full time interval in which the oscillator output signal is in the first state, if the oscillator output signal is in a second state at said start;
    - the frequency detector (14) being provided with a reference input for receiving a reference frequency ($F_{REF}$)
    - where the output ($FO_1$, $FO_2$) of the frequency detector derives from a first voltage level which is either active or inactive and a second voltage level which is either active or inactive, the frequency detector (14) further comprising
    - reset means ($Q_6$, $Q_8$, $Q_{10}$) for terminating a cycle of comparison and starting a new cycle
    - selection means ($Q_7$-$Q_{10}$, 32, 34; $Q_4$-$Q_6$, 42, 44) for activating the first voltage level during a first portion of a cycle of comparison; and for activating the second voltage level during a second portion of a cycle of comparison, the second portion being non-coincident with the first portion;
    - whereby the difference in length of the first and second portions is zero when the signals at the first input and the reference input of the frequency detector have the same frequency, and the sign of said difference corresponds to the sign of the difference of the frequencies between the signals at the first and reference inputs.

2.  A PLL circuit according to Claim 1, characterized in that the frequency detector (14A) comprises a first ($Q_7$), second ($Q_8$), third ($Q_9$) and fourth ($Q_{10}$) D-type flip flop (FF), the D-input of the first ($Q_7$) and the third ($Q_9$) flip flop receiving a constant binary value ( + ); the clock inputs (CLK) of the first ($Q_7$) and second ($Q_8$) flip flop being connected to the reference input ($F_{REF}$), the clock inputs (CLK) of the third ($Q_9$) and the fourth ($Q_{10}$) flip flop being connected to the first input of the frequency detector (VCO); the non-inverting outputs of the first ($Q_7$) and third ($Q_9$) flip flop being connected to the D-inputs of respectively the second ($Q_8$) and the fourth ($Q_{10}$) flip flop whose non-inverting outputs are connected to the inputs of a NAND-gate constituting the reset means, whose output is connected to the reset input (RST) of the flip flops ($Q_7$-$Q_{10}$) of the frequency detector; the frequency detector (14A) further comprising a first and a second two input NOR-gate and a first and a second three input NOR-gate (32), the outputs of the three input NOR-gates being connected to a control input of a first respectively second tristate driver (34), the outputs of which being interconnected for forming the output of the frequency detector ($FO_1$); the inverting outputs of the first ($Q_7$) and third ($Q_9$) flip flop being connected to an input of the first respectively second two input NOR-gate (32); the non-inverting outputs of the

EP 0 164 806 B1

second ($Q_8$) and fourth ($Q_{10}$) flip flop being connected to the second input of the first respectively second two input NOR-gate (32) as well as to an input of the second respectively first three input NOR-gate (32), which latter NOR-gates have their third input connected to the output of the second respectively first NOR-gate for generating complementary binary signals on the outputs of the first and second tristate drivers (34).

3. A PLL according to Claim 1 characterized in that the frequency detector (14B) comprises a fifth ($Q_4$), a sixth ($Q_5$) and a seventh ($Q_6$) D-type flip flop (FF), whereby the first input ($VCO_2$) of the frequency detector is connected to the clock input (CLK) of the seventh flip flop ($Q_6$); the clock inputs (CLK) of the fifth ($Q_4$) and sixth ($Q_5$) flip flop being connected to a reference input ($F_{REF2}$); reset inputs RST of said latter flip flops being connected to the non-inverting output of the seventh flip flop ($Q_6$), to an input of a third tristate driver (46) and to a first input of a first NOR-gate (44), whose output is connected to a control input of the third tristate driver (46); the non-inverting outputs of the fifth ($Q_4$) and sixth ($Q_5$) flip flops being connected to respectively the D-inputs of the sixth ($Q_5$) and seventh ($Q_6$) flip flops; the D-input of the fifth ($Q_4$) flip flop receiving a constant binary value; the non-inverting output of the fifth ($Q_4$) flip flop further being connected to a first input of a first AND-gate (42), whose second input is connected to the inverting output of the sixth flip flop ($Q_5$) and whose output is connected to a second input of the first NOR-gate (44).

4. A PLL according to Claim 1, 2 or 3
   - where the output of the phase detector has a first voltage level which is either active or inactive and a second voltage level which is either active or inactive, and where the First voltage level is activated if the oscillator output signal (VCOIN) is in a first state at the start of the data signal (DATIN) and is inactivated at the next transition of the data signal characterized in that
   - the phase detector comprises
   - a period selection means (21, 22, 23) for activating the second voltage level (DD) during a half period of the oscillator output signal (VCOIN) which is the first half period signal after a start of a cycle
   - where the start of the cycle is activated if the oscillator output signal (VCOIN) is in a second state at the start of the data signal (DATIN).

5. A PLL as claimed in Claim 4, characterized in that the comparison circuit comprises an eighth (21), a ninth (22) and a tenth (23) D-type flip flop; the eighth (21) and the ninth (22) D-type flip flop having their clock input coupled to the data input (DATIN), the tenth D-type flip flop (23) having its clock input coupled to the reset input of the eighth D-flip flop (21) and to the first input (VCOIN).

6. A PLL as claimed in Claim 4 or 5, characterized in that at least one output (PU, PD) of the phase detector (10) is in a high impedance state when both voltage levels are inactive.

7. A PLL as claimed in Claim 4, 5 or 6, characterized in that the phase detector comprises an eighth (21), a ninth (22) and a tenth (23) D-type flip flop (FF), each with a data input (D), a non-inverting output and and inverting output, a clock input and a reset input; the clock inputs of the eighth (21) and ninth (22) flip flop being coupled to the data input (DATIN) of the phase-detector, the clock input of the tenth flip flop (23) being coupled to the reset input of the eighth flip flop (21); the first input (VCOIN) of the phase detector (10) being connected to the D-input of the ninth flip flop (22) and through a first inverter (24) to the reset input of the eighth flip flop (21), said first input (VCOIN) further being connected to a first input of a first NAND-gate (25), whose second input is connected to the inverting output of the ninth flip flop (22) and whose output is connected to the reset input of the tenth flip flop (23), the inverting output of the tenth flip flop (23) being coupled to the reset input of the ninth flip flop (22) and to a control input of a first tristate driver (28); the non-inverting output of the ninth flip flop (22) being connected to the D-input of the tenth flip flop (23); the inverting output of the eighth flip flop (21) being coupled to a control input of a second tristate driver (26) and the D-input of the eighth flip flop (21) receiving a constant binary value ($+5V$); the outputs of said first and second tristate drivers (26, 28) generating complementary binary signals (PU, PD) upon activation of the control inputs, being interconnected to form the output of the phase detector.

**Revendications**

6

1. Circuit à verrouillage de phase (PLL) comprenant :
   - un oscillateur commandé en tension (VCO) (12) avec une sortie d'oscillateur qui est couplée à une première entrée d'un détecteur de fréquence (14) et à une première entrée d'un détecteur de phase (10), les sorties des détecteurs de fréquence et de phase étant couplées respectivement à une première et une seconde entrée d'un filtre de boucle (R1, R2, $C_F$) dont la sortie est couplée à une entrée de commande du VCO (12);
   - le détecteur de phase (10) étant pourvu d'une entrée de données destinée à recevoir un signal de données (DATIN) et comprenant un circuit de comparaison numérique produisant un signal de sortie suite à une séquence de comparaisons d'un cycle du signal de données avec un cycle du signal du VCO, le circuit de comparaison étant déclenché chaque fois par le démarrage d'un signal de données (DATIN) et le signal de sortie produit se trouvant soit dans un premier état (PU) à partir du départ d'un signal de données jusqu'à la transition suivante du signal de sortie d'oscillateur (VCOIN) si le signal de sortie d'oscillateur est à un premier état au départ, soit dans un second état (PD) pendant l'intervalle de temps complet suivant, dans lequel le signal de sortie d'oscillateur se trouve dans le premier état, si le signal de sortie d'oscillateur se trouve dans un second état au départ;
   - le détecteur de fréquence (14) étant pourvu d'une entrée de référence destinée à recevoir une fréquence de référence ($F_{REF}$);
     
     étant entendu que la sortie ($FO_1$, $FO_2$) du détecteur de fréquence provient d'un premier niveau de tension qui est actif ou inactif et d'un second niveau de tension qui est actif ou inactif, le détecteur de fréquence (14) comprenant, en outre :
   - des moyens de repositionnement ($Q_6$, $Q_8$, $Q_{10}$) pour terminer un cycle de comparaison et faire démarrer un nouveau cycle,
   - des moyens de sélection ($Q_7$-$Q_{10}$, 32, 34, $Q_4$-$Q_6$, 42, 44) peur activer le premier niveau de tension pendant une première partie d'un cycle de comparaison et pour activer le second niveau de tension pendant une seconde partie d'un cycle de comparaison, la seconde partie étant non coïncidente avec la première partie;
   - la différence de longueurs de la première et de la seconde partie étant égale à zéro lorsque les signaux à la première entrée et à l'entrée de référence du détecteur de fréquence ont la même fréquence, et le signe de la différence correspondant au signe de la différence des fréquences entre les signaux à la première entrée et à l'entrée de référence.

2. Circuit PLL suivant la revendication 1, caractérisé en ce que le détecteur de fréquence (14A) comprend une première ($Q_7$), une deuxième ($Q_8$), une troisième ($Q_9$) et une quatrième ($Q_{10}$) bascule de type D (FF), l'entrée D de la première bascule ($Q_7$) et de la troisième bascule ($Q_9$) recevant une valeur binaire constante (+); les entrées d'horloge (CLK) de la première bascule ($Q_7$) et de la deuxième bascule ($Q_8$) étant connectées à l'entrée de référence ($F_{REF}$), les entrées d'horloge (CLK) de la troisième bascule ($Q_9$) et de la quatrième bascule ($Q_{10}$) étant connectées à la première entrée du détecteur de fréquence (VCO); les sorties non inverseuses de la première bascule ($Q_7$) et de la troisième bascule ($Q_9$) étant connectées respectivement aux entrées de la deuxième bascule ($Q_8$) et de la quatrième bascule ($Q_{10}$) dont les sorties non inverseuses sont connectées aux entrées d'un circuit-porte NON ET constituant le moyen de repositionnement, dont la sortie est connectée à l'entrée de repositionnement (RST) des bascules ($Q_7$-$Q_{10}$) du détecteur de fréquence; le détecteur de fréquence (14A) comprenant, en outre, un premier et un deuxième circuit-porte NON OU à deux entrées, ainsi qu'un premier et un deuxième circuit-porte NON OU à trois entrées (32), les sorties des circuits-portes NON OU à trois entrées étant connectées à une entrée de commande respective d'un premier et d'un deuxième driver triétats (34), dont les sorties sont interconnectées pour former la sortie du détecteur de fréquence ($FO_1$); les sorties inverseuses de la première bascule ($Q_7$) et de la troisième bascule ($Q_9$) étant connectées à une entrée respective du premier et du deuxième circuit-porte NON OU à deux entrées (32); les sorties non inverseuses de la deuxième bascule ($Q_8$) et de la quatrième bascule ($Q_{10}$) étant connectées à la deuxième entrée respective du premier et du deuxième circuit-porte NON OU à deux entrées (32), ainsi qu'à une entrée respective du deuxième et du premier circuit-porte NON OU à trois entrées (32), ces derniers circuits-portes NON OU étant connectés par leur troisième entrée à la sortie respective du deuxième et du premier circuit-porte NON OU pour produire des signaux binaires complémentaires sur les sorties du premier et du second driver triétats (34).

3. Circuit PLL suivant la revendication 1, caractérisé en ce que le détecteur de fréquence (14B) comprend une cinquième ($Q_4$), une sixième ($Q_5$) et une septième ($Q_6$) bascule de type D (FF), la première entrée

7

(VCO$_2$) du détecteur de fréquence étant connectée à l'entrée d'horloge (CLK) de la septième bascule (Q$_6$); les entrées d'horloge (CLK) de la cinquième bascule (Q$_4$) et de la sixième bascule (Q$_5$) étant connectées à une entrée de référence (F$_{REF2}$); des entrées de repositionnement (RST) de ces dernières bascules étant connectées à la sortie non inverseuse de la septième bascule (Q$_6$), à une entrée d'un troisième driver triétats (46) et à une première entrée d'un premier circuit-porte NON OU (44), dont la sortie est connectée à une entrée de commande du troisième driver triétats (46); les sorties non inverseuses de la cinquième bascule (Q$_4$) et de la sixième bascule (Q$_5$) étant connectées respective-ment aux entrées D de la sixième bascule (Q$_5$) et de la septième bascule (Q$_6$); l'entrée (D) de la cinquième bascule (Q$_4$) recevant une valeur binaire constante; la sortie non inverseuse de la cinquième bascule (Q$_4$) étant, en outre, connectée à une première entrée d'un premier circuit-porte ET (42), dont la seconde entrée est connectée à la sortie inverseuse de la sixième bascule (Q$_5$) et dont la sortie est connectée à la seconde entrée du premier circuit-porte NON OU (44).

4. Circuit PLL suivant la revendication 1, 2 ou 3 :
   - dans lequel la sortie du détecteur de phase présente un premier niveau de tension qui est actif ou inactif et un second niveau de tension qui est actif ou inactif, et dans lequel le premier niveau de tension est activé si le signal de sortie d'oscillateur (VCOIN) se trouve dans un premier état au départ du signal de données (DATIN) et est inactivé à la transition suivante du signal de données, caractérisé en ce que :
   - le détecteur de phase comprend :
   - un dispositif de sélection de période (21, 22, 23) pour activer le second niveau de tension (DD) pendant une demi-période du signal de sortie d'oscillateur (VCOIN) qui est le premier signal de demi-période après le démarrage d'un cycle,
   - le démarrage du cycle étant activé si le signal de sortie d'oscillateur (VCOIN) se trouve dans un second état au départ du signal de données (DATIN).

5. Circuit PLL suivant la revendication 4, caractérisé en ce que le circuit de comparaison comprend une huitième (21), une neuvième (22) et une dixième (23) bascule de type D; la huitième (21) et la neuvième (22) bascule de type D étant connectées, par leur entrée d'horloge, à l'entrée de données (DATIN), la dixième bascule de type D (23) étant connectée par son entrée d'horloge, à l'entrée de repositionnement de la huitième bascule D (21) et à la première entrée (VCOIN).

6. Circuit PLL suivant la revendication 4 ou 5, caractérisé en ce qu'au moins une sortie (PU, PD) du détecteur de phase (10) se trouve dans un état de haute impédance lorsque les deux niveaux de tension sont inactifs.

7. Circuit PLL suivant la revendication 4, 5 ou 6, caractérisé en ce que le détecteur de phase comprend une huitième (21), une neuvième (22) et une dixième (23) bascule de type D (FF), chacune avec une entrée de données D, une sortie non inverseuse et une sortie inverseuse, une entrée d'horloge et une entrée de repositionnement; les entrées d'horloge de la huitième bascule (21) et de la neuvième bascule (22) étant couplées à l'entrée de données (DATIN) du détecteur de phase, l'entrée d'horloge de la dixième bascule (23) étant couplée à l'entrée de repositionnement de la huitième bascule (21); la première entrée (VCOIN) du détecteur de phase (10) étant connectée à l'entrée D de la neuvième bascule (22) et, par l'intermédiaire d'un premier inverseur (24), à l'entrée de repositionnement de la huitième bascule (21), la première entrée (VCOIN) étant, en outre, connectée à une première entrée d'un premier circuit-porte NON ET (25), dont la seconde entrée est connectée à la sortie inverseuse de la neuvième bascule (22) et dont la sortie est connectée à l'entrée de repositionnement de la dixième bascule (23), la sortie inverseuse de la dixième bascule (23) étant connectée à l'entrée de repositionnement de la neuvième bascule (22) et à une entrée de commande d'un premier driver triétats (28); la sortie non inverseuse de la neuvième bascule (22) étant connectée à l'entrée D de la dixième bascule (23); la sortie inverseuse de la huitième bascule (21) étant connectée à une entrée de commande d'un deuxième driver triétats (26) et l'entrée D de la huitième bascule (21) recevant une valeur binaire constante (+ 5V); les sorties des premier et deuxième drivers triétats (26, 28), qui produisent des signaux binaires complémentaires (PU, PD) lors de l'activation des entrées de commande, étant interconnectées pour former la sortie du détecteur de phase.

**Patentansprüche**

1. Phasenverriegelungsschaltung (PLL-Schaltung) mit:
   - einem spannungsgesteuerten Oszillator (VCO) (12) mit einem Oszillatorausgang, der mit einem ersten Eingag eines Frequenzdetektors (14) und einem ersten Eingang eines Phasendetektors (10) gekoppelt ist, wobei die Ausgänge des Frequenz- und des Phasendetektors mit einem ersten bzw. zweiten Eingang eines Schleifenfilters ($R_1$, $R_2$, $C_F$) gekoppelt sind, dessen Ausgang mit einem Steuereingang des VCO (12) gekoppelt ist; wobei
   - der Phasendetektor (10) mit einem Dateneingang zum Empfang eines Datensignals (DATIN) ausgerüstet ist und eine digitale Vergleichsschaltung zur Erzeugung eines Ausgangssignals als Ergebnis einer Folge von Vergleichen eines Zyklus des Datensignals mit einem Zyklus eines vom VCO kommenden Signals enthält, wobei die Vergleichsschaltung jedes Mal durch den Start eines Datensignals (DATIN) getriggert wird und das erzeugte Ausgangssignal entweder in einem ersten Zustand (PU) von dem erwähnten Start eines Datensignals bis zum nächsten Übergang des Oszillatorausgangssignals (VCOIN) ist, wenn das Oszillatorausgangssignal bei dem Start in einem ersten Zustand ist, oder in einem zweiten Zustand (PD) während des folgenden vollständigen Zeitintervalls, in dem das Oszillatorausgangssignal in dem ersten Zustand ist, wenn das Oszillatorausgangssignal bei dem Start in einem zweiten Zustand ist;
   - der Frequenzdetektor (14) mit einem Bezugseingang zum Empfangen einer Eezugsfrequenz ausgerüstet ist ($F_{REF}$);
   - der Ausgang ($FO_1$, $FO_2$) des Frequenzdetektors von einem ersten entweder aktiven oder inaktiven Spannungspegel und einem zweiten entweder aktiven oder inaktiven Spannungspegel stammt, wobei der Frequenzdetektor (14) weiterhin
   - Rücksetzmittel ($Q_6$, $Q_8$, $Q_{10}$) zum Beenden eines Vergleichszyklus und Starten eines neuen Zyklus und
   - Auswahlmittel ($Q_7$-$Q_{10}$, 32, 34; $Q_4$-$Q_6$,42, 44) zum Aktivieren des ersten Spannungspegels während eines ersten Teils eines Vergleichszyklus und zum Aktivieren des zweiten Spannungspegels während eines zweiten, nicht mit dem ersten Teil zusammenfallenden Teils eines Vergleichszyklus
   umfaßt;
   - wobei die Längendifferenz zwischen dem ersten und dem zweiten Teil Null ist, wenn die Signale an dem ersten Eingang und dem Bezugseingang des Frequenzdetektors dieselbe Frequenz haben, und das Vorzeichen der genannten Differenz mit dem Vorzeichen der Differenz der Frequenzen zwischen den Signalen an dem ersten Eingang und dem Bezugseingang übereinstimmt.

2. PLL-Schaltung nach Anspruch 1, dadurch gekennzeichnet, daß der Frequenzdetektor (14A) einen ersten ($Q_7$), zweiten ($Q_8$), dritten ($Q_9$) und vierten ($Q_{10}$) D-Flipflop (FF) enthält, wobei der D-Eingang des ersten ($Q_7$) und des dritten ($Q_9$) Flipflops einen konstanten Binärwert ( + ) empfängt; die Takteingänge (CLK) des ersten ($Q_7$) und zweiten ($Q_8$) Flipflops mit dem Bezugseingang ($F_{REF}$), die Takteingänge (CLK) des dritten ($Q_9$) und vierten ($Q_{10}$) Flipflops mit dem ersten Eingang des Frequenzdetektors (VCO), die nicht-invertierenden Ausgänge des ersten ($Q_7$) und dritten ($Q_9$) Flipflops mit den D-Eingängen des zweiten ($Q_8$) bzw. vierten ($Q_{10}$) Flipflops verbunden sind, und von letzteren die nicht-invertierende Ausgänge mit den Eingängen eines NAND-Gliedes verbunden sind, das das Rücksetzmittel bildet, wobei der Ausgang des NAND-Gliedes mit dem jeweiligen Rücksetzeingang (RST) der Flipflops ($Q_7$-$Q_{10}$) des Frequenzdetektors verbunden ist; der Frequenzdetektor (14A) außerdem ein erstes und ein zweites 2-Eingangs-NOR-Glied und ein erstes und ein zweites 3-Eingangs-NOR-Glied (32) enthält, wobei die Ausgänge der 3-Eingangs-NOR-Glieder mit einem Steuereingang eines ersten bzw. zweiten 3-STATE-Treibers (34) verbunden sind, und die Ausgänge dieser 3-STATE-Treiber miteinander verbunden sind, um den Ausgang des Frequenzdetektors ($FO_1$) zu bilden; wobei die invertierenden Ausgänge des ersten ($Q_7$) und dritten ($Q_9$) Flipflops mit einem Eingang des ersten bzw. zweiten 2-Eingangs-NOR-Gliedes (32); die nicht-invertierenden Ausgänge des zweiten ($Q_8$) und vierten ($Q_{10}$) Flipflops mit dem zweiten Eingang des ersten bzw. zweiten 2-Eingangs-NOR-Gliedes (32) als auch mit einem Eingang des zweiten bzw. ersten 3-Eingangs-NOR-Gliedes (32) verbunden sind; wobei für die letzteren NOR-Glieder ihr dritter Eingang mit dem Ausgang des zweiten bzw. ersten NOR-Gliedes zum Erzeugen komplementärer Binärsignale an den Ausgängen der ersten und zweiten 3-STATE-Treiber (34) verbunden ist.

3. PLL-Schaltung nach Anspruch 1, dadurch gekennzeichnet, daß der Frequenzdetektor (14B) einen fünften ($Q_4$), sechsten ($Q_5$), und siebten ($Q_6$) D-Flipflop (FF) enthält, wobei der erste Eingang ($VCO_2$)

des Frequenzdetektors mit dem Takteingang (CLK) des siebten Flipflops (Q$_6$); die Takteingänge (CLK) des fünften (Q$_4$) und sechsten (Q$_5$) Flipflops mit einem Eezugseingang (F$_{REF2}$) verbunden ist; Rücksetzeingänge RST der letzteren Flipflops mit dem nichtinvertierenden Ausgang des siebten Flipflops (Q$_6$), einem Eingang eines dritten 3-STATE-Treibers (46) und einem ersten Eingang eines ersten NOR-Gliedes (44) verbunden sind, wobei der Ausgang des NOR-Gliedes mit einem Steuereingang des dritten 3-STATE-Treibers (46) verbunden ist; die nicht-invertierenden Ausgänge des fünften (Q$_4$) und sechsten (Q$_5$) Flipflops mit den D-Eingängen des sechsten (Q$_5$) bzw. siebten (Q$_6$) Flipflops verbunden sind; der D-Eingang des fünften (Q$_4$) Flipflops einen konstanten Binärwert empfangt; der nicht-invertierende Ausgang des fünften (Q$_4$) Flipflops außerdem mit einem ersten Eingang eines ersten AND-Gliedes (42) verbunden ist, dessen zweiter Eingang mit dem invertierenden Eingang des sechsten Flipflops (Q$_5$) und dessen Ausgang mit einem zweiten Eingang des ersten NOR-Gliedes (44) verbunden ist.

4. PLL-Schaltung nach Anspruch 1, 2 oder 3,
- wobei der Ausgang des Phasendetektors einen ersten entweder aktiven oder inaktiven Spannungspegel und einen zweiten entweder aktiven oder inaktiven Spannungspegel hat, und wobei der erste Spannungspegel aktiviert wird, wenn das Oszillatorausgangssignal (VCOIN) beim Start des Datensignals (DATIN) in einem ersten Zustand ist, und beim nächsten Übergang des Datensignals inaktiviert wird, dadurch gekennzeichnet, daß
- der Phasendetektor
- ein Periodenauswahlmittel (21, 22, 23) zum Aktivieren des zweiten Spannungspegels (DD) während einer Halbperiode des Oszillatorausgangssignals (VCOIN) enthält, welches das erste Halbperiodensignal nach dem Beginn eines Zyklus ist; wobei der Beginn des Zyklus aktiviert wird, wenn das Oszillatorausgangssignal (VCOIN) beim Start des Datensignals (DATIN) in einem zweiten Zustand ist.

5. PLL-Schaltung nach Anspruch 4, dadurch gekennzeichnet, daß die Vergleichsschaltung einen achten (21), neunten (22) und zehnten (23) D-Flipflop enthält; wobei die Takteingänge des achten (21) und neunten (22) D-Flipflops mit dem Dateneingang (DATIN) und der Takteingang des zehnten D-Flipflops (23) mit dem Rücksetzeingang des achten D-Flipflops (21) und dem ersten Eingang (VCOIN) gekoppelt ist.

6. PLL-Schaltung nach Anspruch 4 oder 5, dadurch gekennzeichnet, daß mindestens ein Ausgang (PU, PD) des Phasendetektors (10) im hohen Impedanzzustand ist, wenn beide Spannungspegel inaktiv sind.

7. PLL-Schaltung nach Anspruch 4, 5 oder 6, dadurch gekennzeichnet, daß der Phasendetektor einen achten (21), neunten (22) und zehnten (23) D-Flipflop (FF) mit jeweils einem Dateneingang (D), einem nicht-invertierenden Ausgang und einem invertierenden Ausgang, einem Takteingang und einem Rücksetzeingang enthält; wobei die Takteingänge des achten (21) und neunten (22) Flipflops mit dem Dateneingang (DATIN) des Phasendetektors und der Takteingang des zehnten Flipflops (23) mit dem Rücksetzeingang des achten Flipflops (21) gekoppelt sind; wobei der erste Eingang (VCOIN) des Phasendetektors (10) mit dem D-Eingang des neunten Flipflops (22) und über einen ersten Inverter (24) mit dem Rücksetzeingang des achten Flipflops (21) verbunden ist und der erwähnte erste Eingang (VCOIN) außerdem mit einem ersten Eingang eines ersten NAND-Gliedes (25) verbunden ist, dessen zweiter Eingang mit dem invertierenden Ausgang des neunten Flipflops (22) und dessen Ausgang mit dem Rücksetzeingang des zehnten Flipflops (23) verbunden ist, wobei der invertierende Ausgang des zehnten Flipflops (23) mit dem Rücksetzeingang des neunten Flipflops (22) und einem Steuereingang eines ersten 3-STATE-Treibers (28) gekoppelt ist; und wobei der nicht-invertierende Ausgang des neunten Flipflops (22) mit dem D-Eingang des zehnten Flipflops (23) verbunden ist, wobei der invertierende Ausgang des achten Flipflops (21) mit einem Steuereingang eines zweiten 3-STATE-Treibers (26) gekoppelt ist und der D-Eingang des achten Flipflops (21) einen konstanten Binärwert (+5V) empfängt; wobei die Ausgänge der ersten und zweiten 3-STATE-Treiber (26, 28), die bei Aktivierung der Steuereingänge komplementäre Binärsignale (PU, PD) erzeugen, zur Bildung des Ausgangs des Phasendetektors miteinander verbunden sind.

FIG.1

FIG.2

FIG.3

FIG. 4

FIG. 5